# EUROPEAN PATENT SPECIFICATION

(11) **EP 1 742 294 B1**
(45) Date of publication and mention of the grant of the patent: **16.04.2008**
(21) Application number: 06019921.3
(22) Date of filing: 10.02.1999
(51) Int. Cl.: H01Q 1/36, H01Q 1/38, H05K 13/04, H01L 21/68, H01L 21/00, B65H 41/00

(54) **A method and a device for manufacturing a roll of items**
Verfahren und Vorrichtung zur Herstellung einer Rolle von Gegenständen
Procédé et dispositif pour la fabrication d'un rouleau d'articles

(43) Date of publication of application: 10.01.2007
(62) Divisional of application: 99850020.1
(73) Proprietor: AMC Centurion AB, 184 25 Akersberga (SE)
(72) Inventor: Morén, Stefan, 164 48 Kista (SE)
(74) Representative: Estreen, Lars J.F.

(56) References cited:
- WO-A-88/08592
- WO-A-97/15093
- GB-A- 2 122 967
- JP-A- 5 211 184
- JP-A- 62 293 737
- US-A- 4 843 404

## Description

### TECHNICAL FIELD OF INVENTION

The present invention relates to a production method for, and a device for facilitating the production of a roll of antenna elements.

### DESCRIPTION OF RELATED ART

The rapid expansion in the mobile telecommunication market and specifically in the radio communication market has led to a tremendous increase in the demand for radio communication devices. Thus the production of such devices increases. For a player on this market to stay competitive it is vital to have competitive products and a smooth manufacturing process for these products.

A specific, important, such product, in the radio communication area, is the antenna device. It is important for the antenna device to adhere to strict requirements of radio frequency characteristics, for instance electric length etc., in the particular radio frequency bands in which it is designed to be operative. These requirements in turn set requirements for the manufacturing process of these devices. For antenna devices designed with a conductive wire formed as a helix the production might result in devices which vary somewhat in the aforementioned characteristics. These devices are however robust, low-cost and has proven to be, once tested to adhere to said requirements, a successful approach in the design of antenna devices for radio communication devices.

An antenna device designed as a conductive pattern on a flexible substrate has proven to be a design with very stable radio frequency characteristics. This is dependent on the accuracy with which it is possible to design the pattern on the flexible substrate. There is also a number of other advantages with using a flexible substrate. It can however be a problem to handle these thin flexible items in the manufacturing process. These problems might include that the items adhere to each other, that they hook in to slits in each other, difficulties in applying them to a coil neck (e.g. the antenna support), that they get stuck in fissures in the manufacturing machines etc. It would therefore be beneficial to have a manufacturing process to use the advantageous flexible substrates which do not have the above mentioned problems in the manufacturing.

WO 88/08592 discloses a method for the manufacture of and structure of a laminated proximity card. However, the method is not suitable for manufacture of radiating elements connectable to radio circuits in a radio communication device. For dispensing techniques e.g. the following three documents are known. GB 2122967 discloses a machine for applying self-adhesive protective labels on papers, cards and the like.

JP 05211184 discloses a device capable of die-bonding pellets with high reliability. JP 62293737 discloses a method for removing a semiconductor small piece from a resin sheet.

### SUMMARY OF INVENTION

One object of the present invention is thus to achieve a device for facilitating the manufacturing of devices comprising printed circuits on flexible substrates. This object is obtained by a device as claimed in claim 12.

Another object of the present invention is to provide a method for manufacturing of a device which facilitates the manufacturing of devices as claimed in claim 1.

An advantage with the present invention is that a smooth and efficient manufacturing process is achieved for the production of printed circuits on a flexible substrate.

An advantage, according to one embodiment of the invention, is that the above mentioned problems are avoided.

An advantage, according to one embodiment of the invention, is that each printed circuit item is well protected from damage and is fed in a controlled manner to a mounting machine.

An advantage, according to one embodiment of the invention, is that the orientation of the printed circuit items can be chosen to fit the specific application or mounting machine.

An advantage, according to one embodiment of the invention, is that it is easy to produce several different printed circuit layouts in one batch.

Further scope of applicability of the present invention will become apparent from the detailed description given hereinafter.

### BRIEF DESCRIPTION OF THE DRAWINGS

The present invention will become more fully understood from the detailed description given hereinbelow and the accompanying drawings which are given by way of illustration only, and thus are not limitative of the present invention and wherein
Figure 1 shows a perspective view of a roll according to a preferred embodiment of the present invention;
Figure 2 shows a side view of a roll according to a preferred embodiment of the invention;
Figure 3 shows a top view of a long flexible film comprising printed circuit items according to a preferred embodiment of the invention;
Figure 4 shows a top view of a long flexible film comprising several parallel printed circuit items according to a preferred embodiment of the invention;
Figures 5a, 5b, 5c, 5d and 5e, discloses a long flexible film after different process steps of in a method according to a preferred embodiment of the invention;
Figures 6a, 6b disclose the final long flexible film after all steps in figure 5.
Figure 7 shows a top view of a conductive circuit according to a preferred embodiment of the invention.

### DETAILED DESCRIPTION OF PREFERRED EMBODIMENTS

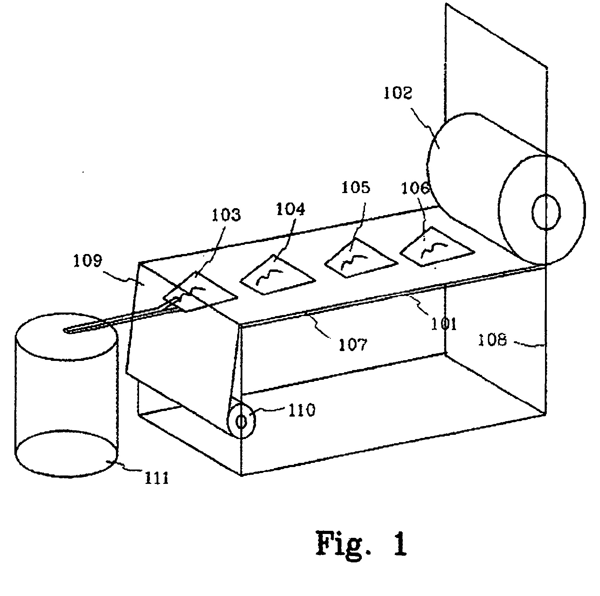

Figure 1 shows a long flexible film 101 arranged in a roll 102. The film 101 comprises antenna elements, whereof four 103, 104, 105 and 106 are visible, and a protective carrier layer 107. The antenna elements consist of etched printed circuits, having specific radio frequency characteristics, applied on a flexible substrate. Between the antenna elements and the protective layer 107 is an adhesive agent present (not shown). The roll 102 is mounted on a stand 108 according to known methods and the film 101 is fed over an edge 109 to a dispose roll 110 which collects the protective layer 107. When the film 101 is fed over the edge 109 the antenna element 103 detach from the protective layer 107. The film 101 is fed so that a convenient part of the antenna element 103 protrudes out from the edge 109. This enables a mounting machine 111 to easy grab the antenna element 103 for mounting on an antenna support structure (not shown). The mounting machine 111 is depicted in a schematic manner in figure 1. Several different arrangements are possible for the mounting machine in dependence of the specific requirements for the specific application.

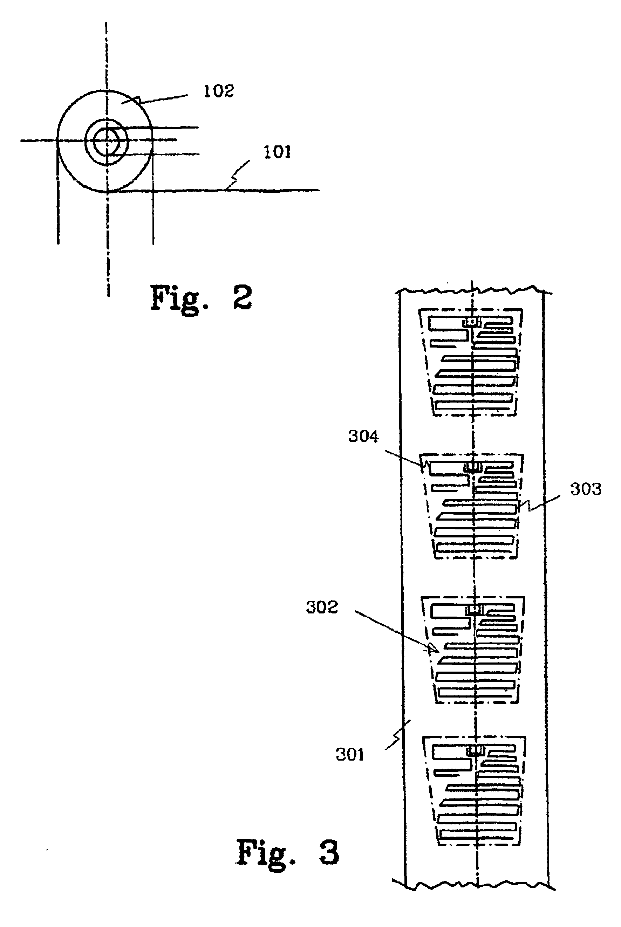

Figure 2 shows the roll 102 comprising antenna elements in a side view.

Figure 3 shows a part of a long flexible carrier film 301, which is to be arranged in a roll, comprising antenna elements 302. The antenna elements in this application are dual band elements having a first and second radiating element 303 and 304, respectively. It is of course also possible to include other types of printed circuits than radiating elements such as for instance a matching circuit etc.

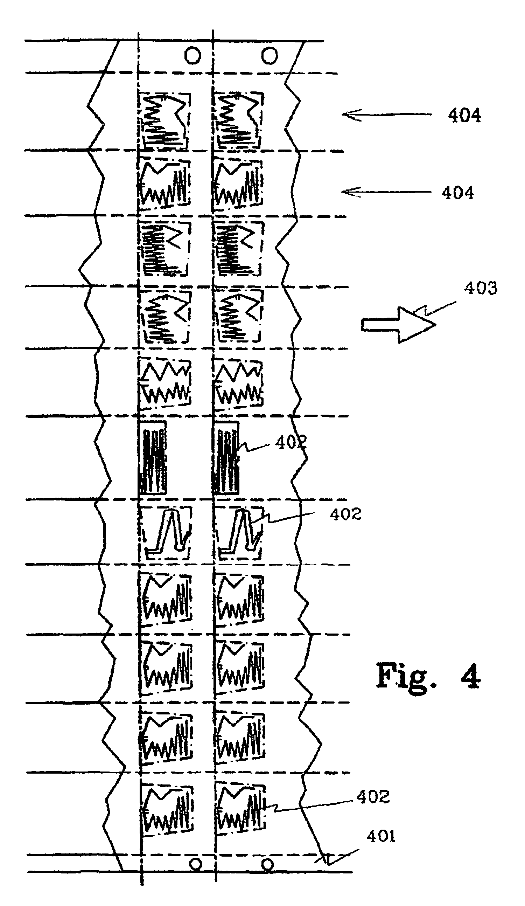

Figure 4 shows a part of a long flexible carrier layer 401, which is to be arranged in a roll, comprising several parallel antenna elements 402 of different size, with different patterns and arranged in different directions. The arrow 403 indicates the direction of roll out. In the production process it might be beneficial to process and manufacture several rolls of printed circuits simultaneously. The different parallel structures 404 are at a later stage in the production process cut in individual rolls.

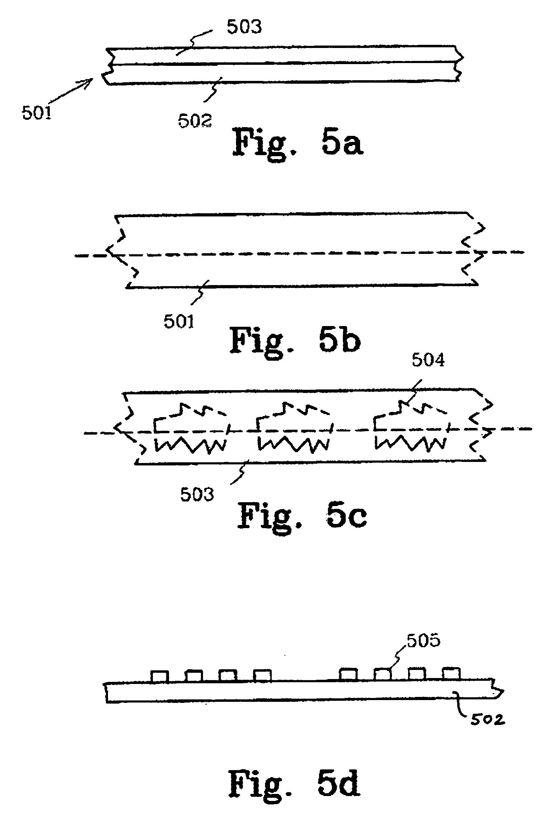

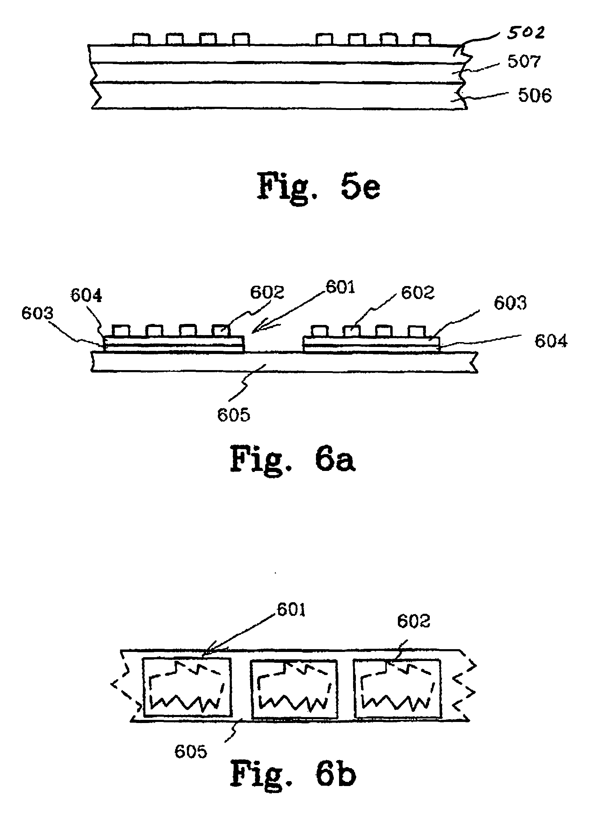

Figure 5-9 show a small part of a long flexible film 501 after different process steps in a method according to a preferred embodiment of the invention. Figure 5a shows a side view, and figure 5b shows a top view, of the long flexible substrate 501 before the first step of the present method. The substrate 510 comprises a first flexible polyester substrate 502 and on top of that a conductive copper layer 503. On the conductive copper layer 503 is a pattern 504 printed, as shown in figure 5c, one after the other, along the long flexible substrate 501, with a paint, which is resistant to the etching fluids later used. Of course, as been previously mentioned, several, different or alike, patterns may be printed in parallel to produce several rolls in one batch. For sake of clarity only one is shown in this preferred embodiment. The substrate 501 is next exposed to etching fluids, which etches away excess copper not covered by said paint so that a conductive pattern, a printed circuit 505, is achieved as shown in a side view in figure 5d. The paint is washed away and a protective layer 506 having an adhesive agent 507 is laminated with the polyester layer carrying the printed circuit 505 as shown in figure 5e to produce the long flexible film. In figure 6a, which shows a side view, and 6b which shows a top view, is the final long flexible film disclosed after the form for the printed circuits 601 has been punched out and excess material removed. The printed circuit item consists of a conductive pattern 602, a flexible carrier 603, and an adhesive agent 604. The printed circuit item is attached to the protective layer 605 under the influence of said adhesive agent 604. Thus has a flexible printed circuit been created which is easily detachable as previously discussed.

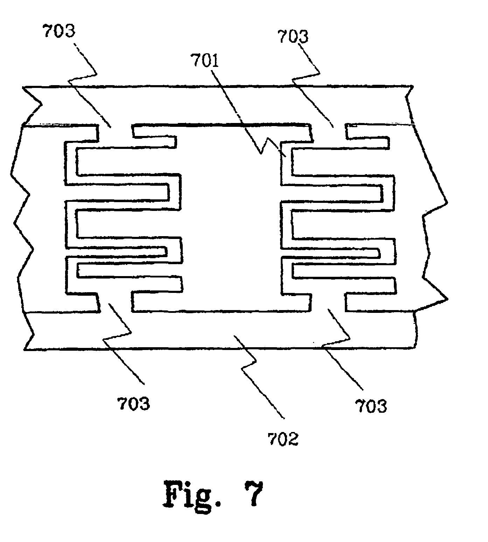

In figure 7 is another preferred embodiment according to the invention disclosed. In this embodiment is a conductive circuit 701 and a carrier 702 formed from the same flexible conductive metallic sheet by punching out a predefined pattern. Said pattern constitutes a radiating antenna device operative in at least a first frequency band and adapted for being coupled to RF circuitry (not shown). The conductive circuit 701 is hold in place on the carrier 702 through small retainer parts 703. The retainer parts 703 are firm enough to hold the conductive circuit in place but weak enough to indestructibly release the conductive circuit 701 in the manufacturing process. Of course may more than two retainer parts be used to hold each conductive circuit 701.

It shall be realized that while a very specific and concrete example has been given the theme may be varied. For instance may a silver-polymer be used as the conductive circuit. Other methods for achieving the printed circuit may be used, for instance may the printed circuit be printed on the flexible carrier using a conductive paint.

## Claims

1. A method for manufacturing a roll of antenna elements including a radiating element, to wherein said antenna elements are suitable for mounting in a radio communication device and said radiating element is connectable to radio circuits in said radio communication device, said method being **characterized by** the steps of:
- screen printing a long flexible first carrier having a metallic layer disposed thereon according to a first pattern with a protective paint,
- etching away the part of said metallic layer not covered by the protective paint, so that a printed circuit is obtained where at least a part of said printed circuit constitutes said radiating element,
- laminating a long flexible protective layer, an adhesive agent and said first carrier together, with said adhesive agent, and
- removing excess material of said first carrier by punching out a contour on said first carrier so that a long flexible film is formed with said long flexible protective layer carrying said antenna elements and where said antenna elements are detachably attached to said protective layer and separated so that each antenna element is detached from neighboring antenna elements.

2. Method according to claim 1, wherein the method further comprises the step of:
- removing said screen paint.

3. Method according to any of claims 1 or 2, wherein the method further comprises the steps of:
- screen printing at least two patterns side by side on said first carrier,
- cutting said long flexible film in at least two parts with one of said at least two patterns on each part.

4. Method according to any of claims 1-3, wherein the method further comprises the steps of:
- arranging said first carrier in a first roll,
- arranging said long flexible protective layer in a second roll,
- unrolling said first carrier from said first roll and said protective layer from said second roll to a third roll.

5. Method according to any of claims 1-4, wherein said two steps of screen printing and etching are exchanged for the step of:
- printing a long flexible first carrier according to a first pattern with a conductive paint and letting it dry.

6. Method according to any of claims 1-5, wherein said adhesive agent having a greater adhesion to said carrier layer than to said protective layer, so as to attach to each of said antenna elements when it is separated from said protective layer.

7. Method according to any of claims 1-6, wherein said antenna elements include at least one further conductive circuit forming at least one element selected from a group consisting of: a radiating element, a parasitic resonator, an inductor, a capacitor, a connector, a marking.

8. Method according to claim 7, wherein said at least one further conductive circuit being conductively, capacitively or inductively coupled to said first conductive circuit.

9. Method according to any of claims 1-8, wherein said antenna elements are arranged to be adhesively attachable to a cylindrical or a spheroid surface.

10. Method according to any of claims 1-9, wherein said radiating element comprises at least a first part having radio frequency characteristics so as to match said radiating element to a predetermined impedance.

11. Method according to any of claims 1-10, wherein said antenna elements are arranged for receiving at least a first discrete component conductively connectable to said radiating element.

12. A device for manufacturing a roll of antenna elements, **characterized in that** it comprises:
- screen printing means for screen printing a long flexible first carrier (502) having a metallic layer (503) disposed thereon according to a first pattern (504) with a protective paint,
- etching means for etching away the part of said metallic layer (503) not covered by the protective paint, so that a printed circuit is obtained,
- laminating means for laminating a long flexible protective layer (107; 506), an adhesive agent (507) and said first carrier (502) together, with said adhesive agent (507), and
- contour punching means for removing excess material of said first carrier (502) by punching out a contour on said first carrier (502) so that a long flexible film is formed with said long flexible protective layer (107; 506) carrying said antenna elements and where said antenna elements are detachably attached to said protective layer (107; 506) and separated so that each antenna element is detached from neighboring antenna elements.

## Patentansprüche

1. Verfahren zum Herstellen einer Rolle von Antennen-Elementen, welche ein abstrahlendes Element beinhalten, wobei die Antennen-Elemente dazu geeignet sind, in einem Funk-Kommunikationsgerät befestigt zu werden, und das abstrahlende Element mit Funk-Schaltungen in dem Funk-Kommunikationsgerät verbindbar ist, wobei das Verfahren durch die Schritte **gekennzeichnet** ist:
- Siebdrucken eines langen flexiblen ersten Trägers, welcher eine darauf aufgebrachte metallische Schicht aufweist, gemäß eines ersten Musters mit einem schützenden Lack,
- Wegätzen des Teils der metallischen Schicht, welcher nicht von dem schützenden Lack bedeckt ist, so dass eine gedruckte Schaltung erhalten wird, wobei zumindest ein Teil der gedruckten Schaltung das abstrahlende Element darstellt,
- Laminieren einer langen flexiblen schützenden Schicht, eines adhäsiven Mittels und des ersten Trägers zusammen, mit dem adhäsiven Mittel, und
- Entfernen von Überschuss-Material des ersten Trägers, indem eine Kontur auf dem ersten Träger ausgestanzt wird, so dass ein langer flexibler Film gebildet wird, wobei der lange flexible Schutz-Film die Antennen-Elemente trägt und wobei die Antennen-Elemente lösbar mit der Schutz-Schicht verbunden sind und so getrennt sind, dass jedes Antennen-Element von benachbarten Antennen-Elementen freistehend ist.

2. Verfahren nach Anspruch 1, wobei das Verfahren ferner den Schritt umfasst:
- Entfernen des Sieb-Lacks.

3. Verfahren nach einem der Ansprüche 1 oder 2, wobei das Verfahren ferner die Schritte umfasst:
- Siebdruckens von zumindest zwei Mustern Seite an Seite auf dem ersten Träger,
- Schneiden des langen flexiblen Films in zumindest zwei Teile mit einem der zumindest zwei Muster in jedem Teil.

4. Verfahren nach einem der Ansprüche 1 bis 3, wobei das Verfahren ferner die Schritte umfasst:
- Anordnen des ersten Trägers in einer ersten Rolle,
- Anordnen der langen flexiblen Schutz-Schicht in einer zweiten Rolle,
- Abrollen des ersten Trägers von der ersten Rolle und der Schutz-Schicht von der zweiten Rolle auf eine dritte Rolle.

5. Verfahren nach einem der Ansprüche 1 bis 4, wobei die beiden Schritte des Siebdruckens und des Ätzens durch den Schritt ersetzt werden:
- Bedrucken eines langen flexiblen ersten Trägers gemäß einem ersten Muster mit einem leitenden Lack und Trocknen lassen.

6. Verfahren nach einem der Ansprüche 1 bis 5, wobei das adhäsive Mittel eine größere Adhäsion zu der Träger-Schicht als zu der Schutz-Schicht aufweist, um an jedes der Antennen-Elemente anzuhängen, wenn es von der Schutz-Schicht getrennt wird.

7. Verfahren nach einem der Ansprüche 1 bis 6, wobei die Antennen-Elemente zumindest eine weitere leitende Schaltung beinhalten, welche zumindest ein Element aus der Gruppe bildet, welche umfasst: ein abstrahlendes Element, ein parasitärer Resonator, eine Spule, ein Kondensator, ein Anschluss, eine Kennzeichnung.

8. Verfahren nach Anspruch 7, wobei die zumindest eine weitere leitende Schaltung leitend, kapazitiv oder induktiv mit der ersten leitenden Schaltung gekoppelt ist.

9. Verfahren nach einem der Ansprüche 1 bis 8, wobei die Antennen-Elemente so angeordnet sind, dass diese adhäsiv an einer zylindrischen oder einer sphäroiden Oberfläche befestigbar sind.

10. Verfahren nach einem der Ansprüche 1 bis 9, wobei das abstrahlende Element zumindest einen ersten Teil umfasst, welcher Hochfrequenz-Charakteristiken aufweist, um das abstrahlende Element an eine vorbestimmte Impedanz anzupassen.

11. Verfahren nach einem der Ansprüche 1 bis 10, wobei die Antennen-Elemente so gestaltet sind, dass diese zumindest eine erste diskrete Komponente aufnehmen, welche mit dem besagten abstrahlenden Element leitend verbindbar ist.

12. Gerät zum Herstellen einer Rolle von Antenzren-Elementen, welches **dadurch** ausgezeichnet ist, dass es umfasst:
- Siebdruck-Mittel zum Siebdrucken eines langen flexiblen ersten Trägers (502), welcher eine darauf aufgebrachte metallische Schicht (503) aufweist, gemäß einem ersten Muster (504) mit einem schützenden Lack,
- Ätz-Mittel zum Wegätzen des Teils der metallischen Schicht (503), welcher nicht von dem schützenden Lack bedeckt ist, so dass eine gedruckte Schaltung erhalten wird,
- Laminier-Mittel zum Laminieren einer langen flexiblen Schutz-Schicht (107; 506), eines adhäsiven Mittels (507) und des besagten ersten Trägers (502) zusammen, mit dem adhäsiven Mittel (507), und
- Kontur-Stanz-Mittel zum Entfernen von Überschuss-Material des besagten ersten Trägers (502), indem eine Kontur auf dem besagten ersten Träger (502) ausgestanzt wird, so dass ein langer flexibler Film gebildet wird, wobei die besagte lange flexible Schutz-Schicht (107; 506) die Antennen-Elemente trägt und wobei die Antennen-Elemente lösbar mit der Schutz-Schicht (107; 506) verbunden sind und so getrennt sind, dass jedes Antennen-Element von benachbarten Antennen-Elementen freistehen ist.

## Revendications

1. Procède de fabrication d'un rouleau d'éléments d'antenne comprenant un élément rayonnant, dans lequel lesdits éléments d'antenne sont adaptés pour un montage dans un dispositif de radiocommunication et ledit élément rayonnant est reliable aux circuits radio dans ledit dispositif de radiocommunication, ledit procédé comprenant les étapes consistant à :
- sérigraphier un premier support flexible et long ayant une couche métallique disposée sur ce dernier selon un premier motif avec une peinture protectrice,
- faire une attaque chimique de la partie de ladite couche métallique non recouverte par la peinture protectrice, de sorte qu'un circuit imprimé est obtenu là où au moins une partie dudit circuit imprime constitue ledit élément rayonnant,
- faire un laminage d'une longue couche protectrice souple, d'un agent adhésif et dudit premier support, ensemble avec ledit agent adhésif, et
- supprimer le surplus de matériau dudit premier support en perforant un contour sur ledit premier support de sorte qu'un long film flexible se forme avec ladite couche protectrice longue et flexible supportant lesdits éléments d'antenne et où lesdits éléments d'antenne sont fixés de façon amovible sur ladite couche protectrice et séparés de sorte que chaque élément d'antenne se détache des éléments d'antenne avoisinants.

2. Procédé selon la revendication 1, dans lequel le procédé comprend en outre l'étape consistant à :
- supprimer ladite peinture sérigraphique.

3. Procédé selon l'une quelconque des revendications 1 ou 2, dans lequel le procédé comprend en outre les étapes consistant à :
- sérigraphier au moins deux motifs côte à côte sur ledit premier support,
- découpez ledit film long et flexible en au moins deux parties avec l'un desdits au moins deux motifs sur chaque partie.

4. Procédé selon l'une quelconque des revendications 1 à 3, dans lequel le procédé comprend en outre les étapes consistant à :
- agencer ledit premier support dans un premier rouleau,
- agencer ladite longue couche protectrice flexible dans un second rouleau,
- dérouler ledit premier support depuis ledit premier rouleau et ladite couche protectrice depuis ledit deuxième rouleau vers un troisième rouleau.

5. Procédé selon l'une quelconque des revendications 1 à 4, dans lequel lesdites deux étapes de sérigraphie et d'attaque chimique sont remplacées par l'étape consistant à:
- imprimer un premier support long et flexible selon un premier motif avec une peinture conductrice et le faire sécher.

6. Procédé selon l'une quelconque des revendications 1 à 5, dans lequel ledit agent adhésif a une plus grande adhérence sur ladite couche de support que sur ladite couche protectrice, de façon à se fixer sur chacun desdits éléments d'antenne lorsqu'il est séparé de ladite couche protectrice.

7. Procédé selon l'une quelconque des revendications 1 à 6, dans lequel lesdits éléments d'antenne comprennent au moins un circuit conducteur supplémentaire formant au moins un élément choisi parmi un groupe consistant en: un élément rayonnant, un résonateur secondaire, une bobine d'induction, un condensateur, un connecteur et un marquage.

8. Procédé selon la revendication 7, dans lequel ledit au moins un circuit conducteur supplémentaire est couplé de façon conductrice, capacitive ou inductive audit premier circuit conducteur.

9. Procédé selon l'une quelconque des revendications 1 à 8, dans lequel lesdits éléments d'antenne sont agencés pour être fixables de façon adhésive sur une surface cylindrique ou sphérique.

10. Procédé selon l'une quelconque des revendications 1 à 9, dans lequel ledit élément rayonnant comprend au moins une première partie ayant des caractéristiques de radiofréquence de façon à s'adapter audit élément rayonnant à une impédance prédéterminée.

11. Procédé selon l'une quelconque des revendications 1 à 10, dans lequel lesdits éléments d'antenne sont agencés pour recevoir au moins un premier composant discret connectable de façon conductrice audit élément rayonnant.

12. Dispositif de fabrication d'un rouleau d'éléments d'antenne **caractérisé en ce qu'**il comprend :
- des moyens de sérigraphie destinés à la sérigraphie d'un premier support long flexible (502) ayant une couche métallique (503) disposée sur cet endroit selon un premier motif (504) avec une peinture protectrice,
- des moyens d'attaque chimique destinés à attaquer chimiquement la partie de ladite couche métallique (503) non recouverte par la peinture protectrice, de sorte qu'un circuit imprimé est obtenu,
- des moyens de laminage destinés à laminer une couche protectrice longue flexible (107 ; 506), un agent adhésif (507) et ledit premier support (502) ensemble, avec ledit agent adhésif (507), et
- des moyens de perforation de contour destinés à supprimer le surplus de matériau dudit premier support (502) en perforant un contour sur ledit premier support (502) de sorte qu'un long film flexible est formé avec ladite couche protectrice longue et flexible (107 ; 506) supportant lesdits éléments d'antenne et où lesdits éléments d'antenne sont fixés de façon amovible à ladite couche protectrice (107 ; 506) et séparés de sorte que chaque élément d' antenne est détaché des éléments d'antenne avoisinants.
